(19) **Europäisches Patentamt / European Patent Office / Office européen des brevets**

(11) **EP 2 645 569 B1**

(12) **FASCICULE DE BREVET EUROPEEN**

(45) Date de publication et mention de la délivrance du brevet:
**02.01.2019 Bulletin 2019/01**

(51) Int Cl.:
*H03K 17/10* $^{(2006.01)}$     *H02M 1/088* $^{(2006.01)}$

(21) Numéro de dépôt: **13157990.6**

(22) Date de dépôt: **06.03.2013**

(54) **Dispositif de commande employé dans un système d'alimentation électrique à découpage**

Steuervorrichtung, die in einem Stromzuführungssystem mit Partitionierung verwendet wird

Control device employed in a switched electrical power supply system

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.03.2012 FR 1252956**

(43) Date de publication de la demande:
**02.10.2013 Bulletin 2013/40**

(73) Titulaire: **Schneider Toshiba Inverter Europe SAS 27120 Pacy sur Eure (FR)**

(72) Inventeurs:
- **Boulharts, Hocine**
  **78510 Triel sur Seine (FR)**
- **Barauna, Allan Pierre**
  **27200 Vernon (FR)**

(74) Mandataire: **Dufresne, Thierry et al Schneider Electric Industries SAS Service Propriété Industrielle 35 rue Joseph Monier - CS 30323 92506 Rueil-Malmaison Cedex (FR)**

(56) Documents cités:
**EP-A1- 0 048 758**     **EP-A2- 0 453 376**
**JP-A- 2006 158 185**     **US-B1- 7 348 826**

- **HERBERT L HESS ET AL: "Transformerless Capacitive Coupling of Gate Signals for Series Operation of Power MOS Devices", IEEE TRANSACTIONS ON POWER ELECTRONICS, IEEE SERVICE CENTER, PISCATAWAY, NJ, US, vol. 15, no. 5, 5 septembre 2000 (2000-09-05), XP011043472, ISSN: 0885-8993**

**Description**

**Domaine technique de l'invention**

La présente invention se rapporte à un dispositif de commande employé dans un système d'alimentation électrique à découpage. L'invention concerne également le système d'alimentation électrique à découpage employant ledit dispositif de commande.

**Etat de la technique**

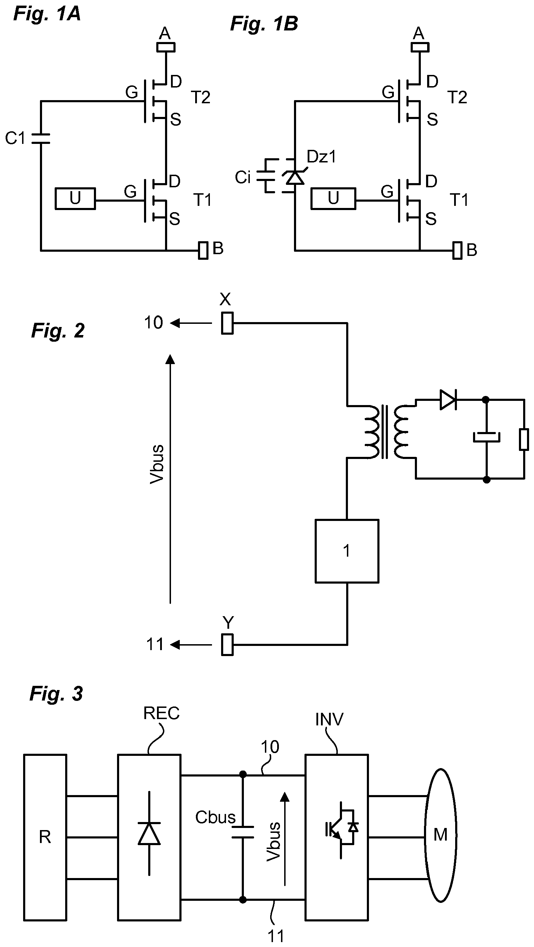

Un système d'alimentation électrique à découpage (appelé également SMPS pour "Switched Mode Power Supply") permet de délivrer en sortie une ou plusieurs tensions continues à partir d'une tension continue prélevée en entrée. Ce type de système d'alimentation électrique à découpage est notamment employé dans un variateur de vitesse. Dans un variateur de vitesse, le système d'alimentation électrique à découpage est alors chargé de fournir une tension continue auxiliaire permettant d'alimenter toute l'électronique du variateur de vitesse, à partir d'une tension continue principale prélevée sur le bus continu d'alimentation du variateur de vitesse.
Le bus continu d'alimentation fournit une tension continue principale pouvant aller de 350 Vcc à plus de 1000 Vcc. Le dispositif de commande employé dans le système d'alimentation électrique à découpage doit ainsi pouvoir commuter un courant allant jusqu'à 2A sous 1700 Vcc. De manière connue, le dispositif de commande peut comporter un seul transistor de type MOSFET ayant une tension de claquage comprise entre 1200 V et 1700V. Cependant, à ces tensions de claquage, le transistor MOSFET est à ses limites technologiques. De plus, son coût est élevé et, en fonctionnement, ses pertes par effet joule sont particulièrement élevées.
Pour pallier ces inconvénients, il est connu d'associer deux transistors MOSFET en série, ayant des tensions de claquage plus faibles, allant de 600V à 900V. Chacun des deux transistors en série supporte ainsi une tension électrique moindre, compatible avec un emploi optimal de la technologie des MOSFET.
Des dispositifs de commande sont également connus des documents EP0453376A2 et JP2006158185A.
Dans l'état de la technique, plusieurs montages à deux transistors en série ont été proposés. La publication intitulée "Transformerless Capacitive Coupling of Gate Signais for Sériés Operation of Power MOS Devices" - Robert L. Hess et Russel Jacob Baker- IEEE transactions on power electronics, Vol. 15, N°5, Septembre 2000, décrit un dispositif de commande comportant au moins deux transistors de type MOSFET en série. Cette topologie est représentée sur la figure 1A. Dans cette topologie, le dispositif de commande comporte deux bornes d'entrée A, B et un premier transistor T1 connecté à la deuxième borne d'entrée B et recevant sur sa grille des signaux de commande provenant d'une unité de commande U. Un deuxième transistor T2 est connecté en série avec le premier transistor T1 et à la première borne d'entrée A. Un condensateur C1 est connecté entre la grille du deuxième transistor T2 et la première borne d'entrée A. Le rôle du condensateur C1 est double : fournir assez de charge pour contrôler le deuxième transistor et limiter la tension aux bornes du premier transistor à une valeur optimale.
Pour ne pas être tributaire de ces deux conditions, il a notamment été proposé de remplacer le condensateur par une diode zener Dz1, qui permet alors de fixer la tension aux bornes du premier transistor T1. Cette deuxième topologie connue est représentée sur la figure 1B. Dans ce montage, le contrôle du deuxième transistor T2 est alors assuré grâce à la charge emmagasinée par la capacité intrinsèque (Ci) de la diode zener Dz1. Cependant, si la charge transmise par la capacité intrinsèque de la diode zener Dz1 est inférieure (due par exemple à une tension du bus continue trop faible) à la charge nécessaire à contrôler correctement le deuxième transistor T2, il est alors nécessaire d'ajouter un condensateur en parallèle de cette diode zener pour assurer un contrôle adapté du deuxième transistor. En ajoutant le condensateur en parallèle de la diode zener, les inconvénients identifiés pour le premier montage refont leur apparition.
Dans ces deux montages, le contrôle du deuxième transistor T2 dépend de la capacité du condensateur, intrinsèque ou additionnel, et du niveau de la tension aux bornes du condensateur. Pour contrôler de manière adaptée le deuxième transistor T2, à partir d'une tension qui est basse aux bornes du condensateur (intrinsèque à la diode zener Dz1 ou additionnel), il est nécessaire d'augmenter la capacité du condensateur connecté en série à la grille G du transistor T2. Or la capacité du condensateur ne peut pas être augmentée indéfiniment.
Le but de l'invention est de proposer un dispositif de commande à plusieurs transistors en série, destiné à être employé dans un système d'alimentation électrique à découpage, le dispositif de commande permettant un contrôle adapté du deuxième transistor quel que soit le niveau de la tension continue principale, et sans augmenter la capacité d'un condensateur.

**Exposé de l'invention**

Ce but est atteint par un dispositif de commande selon la revendication 1.
L'invention concerne également un système d'alimentation électrique à découpage selon la revendication 4.

L'invention concerne également un variateur de vitesse selon la revendication 9.

## Brève description des figures

D'autres caractéristiques et avantages vont apparaître dans la description détaillée qui suit faite en regard des dessins annexés dans lesquels :

- la figure 1A représente un dispositif de commande à deux transistors en série, selon un premier état de la technique,
- la figure 1B représente un dispositif de commande à deux transistors en série, selon un deuxième état de la technique,
- la figure 2 représente un système d'alimentation électrique à découpage,
- la figure 3 représente un variateur de vitesse employant un système d'alimentation électrique à découpage de l'invention,
- les figures 4A à 4E représentent un dispositif de commande à deux transistors en série,
- la figure 5 représente un motif pouvant être cascadé plusieurs fois sur le dispositif de commande représenté sur les figures 4A à 4E,
- la figure 6 représente un dispositif de commande de l'invention, comprenant plusieurs transistors en cascade.

## Description détaillée d'au moins un mode de réalisation

Les solutions présentées sur les figures 1A et 1B font partie de l'état de la technique et ont été décrites ci-dessus, dans la partie introductive de la description.

Dans la suite de la description, certains références employées dans la description des figures 1A et 1B sont conservées pour la description de l'invention, dans la mesure où les composants employés sont identiques et remplissent une fonction identique.

L'invention concerne un dispositif de commande 1 destiné à être employé dans un système d'alimentation électrique à découpage. Un tel système d'alimentation électrique à découpage est employé dans un variateur de vitesse, tel que représenté sur la figure 3.

En référence à la figure 3, un variateur de vitesse est alimenté à partir d'un réseau R d'alimentation électrique triphasé délivrant une tension alternative et est basé sur une topologie AC/DC/AC (AC=Courant Alternatif, DC=Courant Continu). Un tel variateur de vitesse comporte ainsi :

- un module redresseur REC destiné à redresser la tension alternative fournie par le réseau,

- un bus continu d'alimentation connecté au module redresseur et comportant une première ligne d'alimentation 10 à potentiel électrique positif et une deuxième ligne d'alimentation 11 à potentiel électrique négatif entre lesquelles est appliquée une tension continue Vbus principale fournie par le module redresseur,

- un condensateur de bus Cbus connecté à la première ligne d'alimentation 10 et à la deuxième ligne d'alimentation 11 et chargé de maintenir la tension continue Vbus à une valeur constante,

- un module onduleur INV comportant plusieurs transistors de commutation destinés à convertir la tension continue disponible sur le bus en une tension variable à destination d'une charge électrique M.

La tension continue Vbus principale est employée pour alimenter le système d'alimentation électrique à découpage. Le système d'alimentation électrique à découpage est notamment employé pour fournir une tension de commande aux transistors du module onduleur INV.

Un système d'alimentation électrique à découpage, tel que représenté sur la figure 2, comporte une première borne X destinée à être connectée à la première ligne d'alimentation 10 et une deuxième borne Y destinée à être connectée à la deuxième ligne d'alimentation 11 du bus continu d'alimentation. Le système comporte un convertisseur continu/continu connecté à sa première borne X et un dispositif de commande 1 connecté en série avec le convertisseur continu/continu et à sa deuxième borne Y. Le convertisseur continu/continu peut se présenter sous la forme de différentes topologies connues, telles que par exemple "flyback" isolé, "forward" isolé, abaisseur ("buck") ou élévateur ("boost"). La figure 2 montre l'association entre le dispositif de commande de l'invention et un convertisseur de type "flyback".

En référence à la figure 1A, le dispositif de commande 1 de l'invention comporte deux bornes d'entrée A, B. La première borne d'entrée A est destinée à être connectée au convertisseur continu/continu du système d'alimentation électrique à découpage et la deuxième borne d'entrée B est destinée à être connectée à la deuxième borne Y du système.

Le dispositif de commande 1 comporte deux transistors T1, T2 connectés en série entre sa première borne d'entrée A et sa deuxième borne d'entrée B. Préférentiellement, chacun des transistors est un MOSFET, un IGBT ou un transistor fabriqué dans un matériau à grande énergie de bande interdite ("wide-band gap material") tel que le carbure de silicium ou le nitrure de gallium. Choisir deux transistors en série permet de diviser par deux la tension supportée aux bornes de chacun des transistors, et donc de diminuer leur coût et leur encombrement par rapport à un seul transistor supportant l'intégralité de la tension.

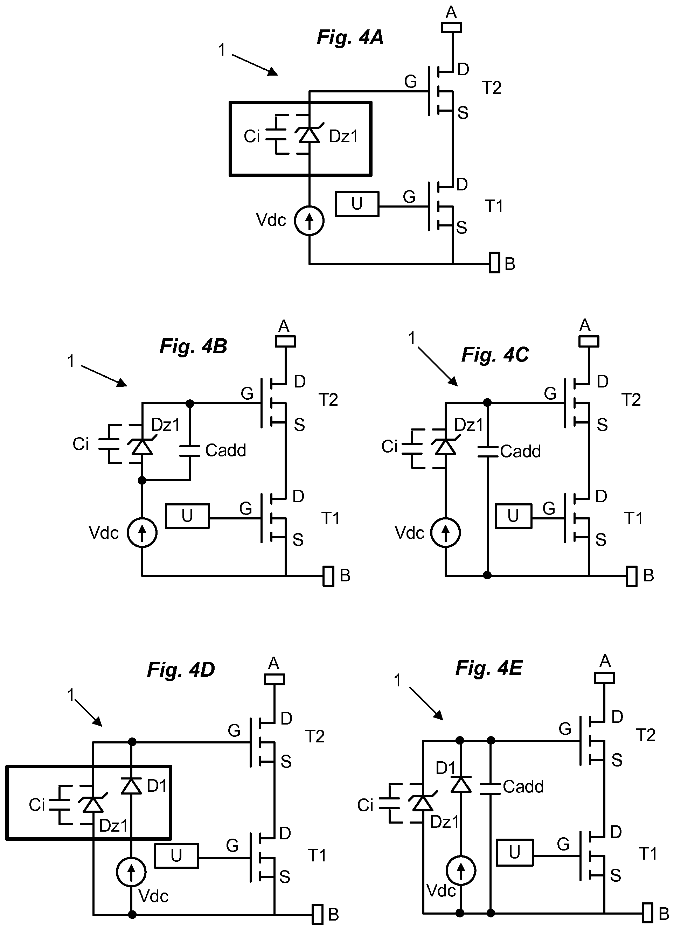

Chaque transistor T1, T2 possède une grille G dont la commande permet de faire passer un courant entre un drain D et une source S. Comme représenté sur la figure 4A, la source S du premier transistor T1 est connectée à la deuxième borne d'entrée B, la source S du deuxième transistor T2 est connectée au drain D du premier transistor T1 et le drain du deuxième transistor T2 est connecté à la première borne d'entrée A.

La grille G du premier transistor T1 est connectée à une unité de commande U délivrant des signaux de commande, par exemple de type MLI (Modulation de Largeur d'Impulsion ou PWM pour "Pulse Width Modulation"), pour commander le premier transistor T1 à l'ouverture ou à la fermeture. La grille G du deuxième transistor T2 est à commande flottante. Ainsi, elle est connectée à la deuxième borne d'entrée B à travers un ensemble de commande spécifique, objet de l'invention.

Cet ensemble de commande comporte une source de tension Vdc connectée à la deuxième borne d'entrée et un dispositif d'écrêtage/aiguillage de tension connecté à la source de tension Vdc et à la grille G du deuxième transistor T2.

Dans une première variante de réalisation représentée sur les figures 4A, 4B, 4C, le dispositif d'écrêtage/aiguillage de tension comporte une diode zener Dz1 connectée en série avec la source de tension Vdc.

Dans une deuxième variante de réalisation représentée sur les figures 4D et 4E, le dispositif d'écrêtage/aiguillage de tension comporte une diode D1 connectée à la grille G du deuxième transistor T2 et en série avec la source de tension Vdc et une diode zener Dz1 connectée en parallèle de la source de tension Vdc et de la diode D1.

Sur les figures 4A à 4C, la diode zener Dz1 joue un double rôle : le rôle d'écrêteur de tension pour limiter la tension aux bornes du premier transistor T1 à la tension inverse de la diode zener Dz1 et le rôle de diode permettant d'aiguiller la tension Vdc vers la grille G du deuxième transistor T2 lors de la fermeture du dispositif.

La source de tension Vdc permet de garantir une tension suffisante pour commander le deuxième transistor T2, par exemple lors du démarrage d'un système d'alimentation électrique à découpage, même si la capacité (condensateur intrinsèque de la diode zener) connectée en série est insuffisante pour la commande du deuxième transistor T2.

En référence aux figures 4B, 4C, 4E, pour limiter la dissipation dans la diode zener Dz1, il est possible d'ajouter un condensateur additionnel Cadd. Ce condensateur additionnel Cadd est connecté en parallèle de la diode zener seule (figure 4B) ou en parallèle de l'ensemble de commande en totalité (figures 4C et 4E). La valeur de la capacité de ce condensateur additionnel Cadd est choisie de manière à pouvoir synchroniser l'ouverture des deux transistors et à représenter un compromis entre les pertes générées dans le premier transistor T1 et les pertes générées dans la diode zener Dz1.

Selon l'invention, l'ajout de la source de tension Vdc dans la commande de la grille G du deuxième transistor T2 retire ainsi toute contrainte de dimensionnement d'un quelconque condensateur connecté en série. Elle permet de garantir le bon fonctionnement du deuxième transistor et de s'assurer que celui-ci passe le seuil de conduction.

Le fonctionnement du dispositif de commande tel que représenté à la figure 4B, 4C ou 4E est le suivant :

A la fermeture :

A $t_0$ : les deux transistors sont ouverts. La tension aux bornes de la diode zener Dz1 s'applique aux bornes du premier transistor T1. L'unité de commande U envoie un signal de fermeture sur la grille du premier transistor T1.

Entre $t_0$ et $t_1$ : le premier transistor T1 étant en cours de fermeture, la tension à ses bornes, entre drain et source, diminue. Cette diminution force la décharge du condensateur aux bornes de la diode zener Dz1 vers la grille du deuxième transistor T2. Un courant charge alors la grille G du deuxième transistor T2.

A $t_1$ : lorsque suffisamment de charges se sont accumulées sur la grille G du deuxième transistor T2, le deuxième transistor T2 se ferme. La source de tension permet de garantir le passage du seuil de conduction du deuxième transistor T2.

A l'ouverture :

A $t_0$ : les deux transistors sont fermés. L'unité de commande U envoie un signal d'ouverture sur la grille G du premier transistor T1.

Entre $t_0$ et $t_1$ : la tension aux bornes du transistor T1 augmente, entraînant l'augmentation de la tension aux bornes de la diode zener Dz1. Un courant circule alors de la grille du transistor T2 vers la diode zener Dz1 et le condensateur, entraînant la décharge de la grille du deuxième transistor T2. Le condensateur additionnel Cadd permet alors de stocker l'énergie de décharge du deuxième transistor T2. La valeur de la capacité du condensateur additionnel Cadd est ainsi choisie pour régler la durée de commutation à l'ouverture du deuxième transistor T2, par exemple de manière à synchroniser l'ouverture du deuxième transistor T2 avec l'ouverture du premier transistor T1. La diode zener Dz1 fixe pour sa part la tension maximale sur le premier transistor T1.

A $t_1$ : les deux transistors sont ouverts.

Partant des architectures décrites ci-dessus, l'invention consiste également à cascader des transistors au-dessus du deuxième transistor T2.

Pour effectuer cela, il est possible de superposer un ou plusieurs motifs identiques sur l'architecture décrite précédemment et comprenant les deux transistors T1, T2. Le premier motif est connecté à la grille G et au drain D du deuxième transistor T2.

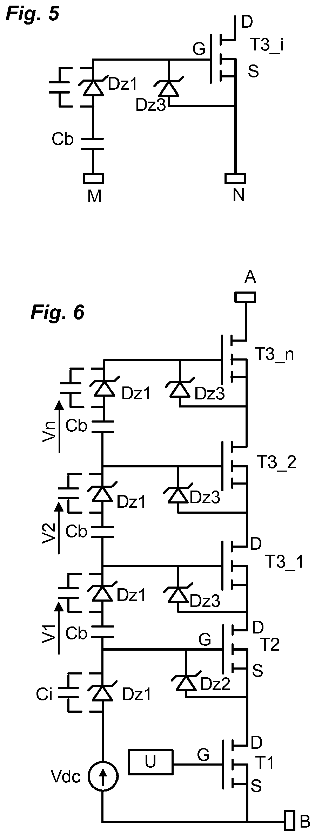

En référence à la figure 5, un motif comporte deux points de connexion M, N. Chaque motif comporte un condensateur Cb connecté à un premier point de connexion M, une diode zener Dz1, identique à la précédente pour respecter le partage des tensions, connectée en série avec le condensateur Cb, un transistor T3_i (i=1 à n), du même type que les transistors T1, T2 principaux, dont la grille G est connectée à la diode zener Dz1, et la source S est connectée à un deuxième point de connexion N. Le motif comporte également une diode zener Dz3 (identique ou non à Dz2) connectée entre la grille G et la source S du transistor T3_i.

Chaque motif ajouté vient se connecter par son deuxième point de connexion N sur le drain D du transistor (T3_n-1) du motif précédent et par son premier point de connexion M sur la grille G du transistor (T3_n-1) du motif précédent.

Le drain D du transistor du dernier motif (T3_n) est connecté à la première borne d'entrée A décrite ci-dessus.

A l'ouverture du premier transistor T1 commandée par l'unité de commande U, les capacités parasites des transistors en cascade se chargent par un courant (venant du convertisseur). La tension aux bornes de chaque transistor T3_i est écrêtée à la tension de sa diode zener Dz1. Les diodes zener conduisent et chargent les condensateurs Cb des motifs.

A la fermeture, la tension aux bornes de chaque condensateur Cb des motifs, compense les chutes de tension de la diode zener en conduction direct (tension VfwDz1) et du transistor sous jacent en conduction . Cette tension Vn aux bornes de chaque condensateur Cb d'un motif s'exprime de la manière suivante :

$$V1 = V_{Dz3} - (Vdc\text{-}Vfw_{Dz1}) + Vfw_{Dz1} + Id_{T2} * Rds_{on\_T2}$$

$$Vn = V_{Dz3} - (Vdc\text{-}Vfw_{Dz1}) + Vfw_{Dz1} + Id_{Tn\text{-}1} * Rds_{on\_Tn\text{-}1}$$

L'invention porte ainsi sur un dispositif de commande 1 à fonctionnement optimisé, pouvant être employé dans un système d'alimentation électrique à découpage tel que décrit ci-dessus. Un tel système peut notamment être employé dans un variateur de vitesse tel que décrit ci-dessus.

## Revendications

1. Dispositif de commande (1) configuré pour être employé dans un système d'alimentation électrique à découpage pour commander un convertisseur continu/continu dudit système d'alimentation électrique à découpage, ledit dispositif de commande comportant :

   - une première borne d'entrée (A) et une deuxième borne d'entrée (B),
   - un premier transistor (T1) connecté à la deuxième borne d'entrée (B) et doté d'une grille (G) destinée à être connectée à une unité de commande (U) destinée à émettre des signaux de commande sur sa grille, et
   - un deuxième transistor (T2) en série avec le premier transistor (T1), et doté d'une grille (G),
   - un ensemble de commande destiné à la commande du deuxième transistor (T2), connecté à la grille (G) du deuxième transistor (T2) et à la deuxième borne d'entrée (B) et comprenant une source de tension (Vdc) et une diode zener (Dz1) connectée en série avec la source de tension (Vdc),
   - plusieurs motifs identiques, chaque motif comprenant :

     - un premier (M) et un deuxième (N) points de connexion,
     - un condensateur (Cb) connecté au premier point de connexion (M),
     - une première diode zener (Dz1) connectée en série avec ledit condensateur (Cb),
     - un troisième transistor (T3_i) doté d'une grille (G) connectée à ladite première diode zener et d'une source (S) connectée au deuxième point de connexion (N),
     - une seconde diode zener (Dz3) connectée entre la grille (G) et la source (S) du troisième transistor (T3_i),
     - le premier motif ajouté venant se connecter par son deuxième point de connexion (N) sur le drain (D) du deuxième transistor (T2) et par son premier point de connexion (M) sur la grille (G) du deuxième transistor (T2),

- chaque motif supplémentaire venant se connecter par son deuxième point de connexion (N) sur le drain (D) du troisième transistor (T3_n-1) du motif précédent et par son premier point de connexion (M) sur la grille (G) du troisième transistor (T3_n-1) du motif précédent,

le drain du troisième transistor du dernier motif étant connecté à la première borne d'entrée (A).

2. Dispositif selon la revendication 1, **caractérisé en ce qu'**il comprend un condensateur additionnel (Cadd) connecté en parallèle de la diode zener (Dz1).

3. Dispositif selon la revendication 1 **caractérisé en ce qu'**il comprend un condensateur additionnel (Cadd) connecté en parallèle de l'ensemble de commande.

4. Système d'alimentation électrique à découpage comprenant une première borne (X) et une deuxième borne (Y) entre lesquelles est connectée une source de tension continue, un convertisseur continu/continu connecté à la première borne (X) et un dispositif de commande (1) connecté en série avec le convertisseur continu/continu et à la deuxième borne (Y), **caractérisé en ce que** ledit dispositif de commande (1) est conforme à celui défini dans l'une des revendications 1 à 3.

5. Système selon la revendication 4, **caractérisé en ce que** le convertisseur continu/continu est de type "flyback" isolé.

6. Système selon la revendication 4, **caractérisé en ce que** le convertisseur continu/continu est de type "forward" isolé.

7. Système selon la revendication 4, **caractérisé en ce que** le convertisseur continu/continu est de type élévateur.

8. Système selon la revendication 4, **caractérisé en ce que** le convertisseur continu/continu est de type abaisseur.

9. Variateur de vitesse destiné à commander une charge électrique (M), comportant :

   - un module redresseur (REC) destiné à redresser une tension alternative fournie par un réseau (R) de distribution électrique,
   - un bus continu d'alimentation connecté au module redresseur (REC) et comportant une première ligne d'alimentation (10) à potentiel électrique positif et une deuxième ligne d'alimentation (11) à potentiel électrique négatif entre lesquelles est appliquée une tension continue (Vbus) principale fournie par le module redresseur,
   - un condensateur de bus (Cbus) connecté à la première ligne d'alimentation (10) et à la deuxième ligne d'alimentation (11),
   - un module onduleur (INV) comportant plusieurs transistors de commutation destinés à convertir la tension continue (Vbus) disponible sur le bus en une tension variable à destination de la charge électrique (M),

   **caractérisé en ce qu'**il comporte :

   - un système d'alimentation électrique à découpage conforme à celui défini dans l'une des revendications 4 à 8 et **en ce que** la première borne (X) du système d'alimentation électrique à découpage est connectée à la première ligne d'alimentation (10) du bus continu d'alimentation et la deuxième borne (Y) du système d'alimentation électrique à découpage est connectée à la deuxième ligne d'alimentation (11) du bus continu d'alimentation.

**Patentansprüche**

1. Steuervorrichtung (1), welche dafür ausgelegt ist, in einem Schaltnetzteil eingesetzt zu werden, um einen Gleichspannungswandler dieses Schaltnetzteils zu steuern, wobei die Steuervorrichtung aufweist:

   - eine erste Eingangsklemme (A) und eine zweite Eingangsklemme (B),
   - einen ersten Transistor (T1), der mit der zweiten Eingangsklemme (B) verbunden ist und mit einem Gate (G) versehen ist, das dazu bestimmt ist, mit einer Steuereinheit (U) verbunden zu werden, die dazu bestimmt ist, Steuersignale an das Gate zu senden,

- einen zweiten Transistor (T2), der mit dem ersten Transistor (T1) in Reihe geschaltet ist und mit einem Gate (G) versehen ist,
- eine Steueranordnung, die für die Steuerung des zweiten Transistors (T2) bestimmt ist, mit dem Gate (G) des zweiten Transistors (T2) und mit der zweiten Eingangsklemme (B) verbunden ist und eine Spannungsquelle (Vdc) und eine mit der Spannungsquelle (Vdc) in Reihe geschaltete Zenerdiode (Dz1) umfasst,
- mehrere identische Einheiten, wobei jede Einheit umfasst:
- einen ersten (M) und einen zweiten (N) Anschlusspunkt;
- einen Kondensator (Cb), der mit dem ersten Anschlusspunkt (M) verbunden ist,
- eine erste Zenerdiode (Dz1), die mit dem Kondensator (Cb) in Reihe geschaltet ist,
- einen dritten Transistor (T3_i), der mit einem Gate (G), das mit der ersten Zenerdiode verbunden ist, und einer Source (S), die mit dem zweiten Anschlusspunkt (N) verbunden ist, versehen ist,
- eine zweite Zenerdiode (Dz3), die zwischen das Gate (G) und die Source (S) des dritten Transistors (T3_i) geschaltet ist,
- wobei die erste hinzugefügte Einheit über ihren zweiten Anschlusspunkt (N) an den Drain (D) des zweiten Transistors (T2) und über ihren ersten Anschlusspunkt (M) an das Gate (G) des zweiten Transistors (T2) angeschlossen wird,
- wobei jede zusätzliche Einheit über ihren zweiten Anschlusspunkt (N) an den Drain (D) des dritten Transistors (T3_n-1) der vorhergehenden Einheit und über ihren ersten Anschlusspunkt (M) an das Gate (G) des dritten Transistors (T3_n-1) der vorhergehenden Einheit angeschlossen wird,

wobei der Drain des dritten Transistors der letzten Einheit mit der ersten Eingangsklemme (A) verbunden ist.

2. Vorrichtung nach Anspruch 1, **dadurch gekennzeichnet, dass** sie einen zusätzlichen Kondensator (Cadd) umfasst, der zu der Zenerdiode (Dz1) parallelgeschaltet ist.

3. Vorrichtung nach Anspruch 1, **dadurch gekennzeichnet, dass** sie einen zusätzlichen Kondensator (Cadd) umfasst, der zu der Steueranordnung parallelgeschaltet ist.

4. Schaltnetzteil, welches eine erste Klemme (X) und eine zweite Klemme (Y), zwischen die eine Gleichspannungsquelle geschaltet ist, einen Gleichspannungswandler, der mit der ersten Klemme (X) verbunden ist, und eine Steuervorrichtung (1), die mit dem Gleichspannungswandler in Reihe geschaltet und mit der zweiten Klemme (Y) verbunden ist, umfasst, **dadurch gekennzeichnet, dass** die Steuervorrichtung (1) mit derjenigen konform ist, die in einem der Ansprüche 1 bis 3 definiert ist.

5. System nach Anspruch 4, **dadurch gekennzeichnet, dass** der Gleichspannungswandler vom Typ eines isolierten Sperrwandlers ist.

6. System nach Anspruch 4, **dadurch gekennzeichnet, dass** der Gleichspannungswandler vom Typ eines isolierten Eintaktflusswandlers ist.

7. System nach Anspruch 4, **dadurch gekennzeichnet, dass** der Gleichspannungswandler vom Typ eines Aufwärtswandlers ist.

8. System nach Anspruch 4, **dadurch gekennzeichnet, dass** der Gleichspannungswandler vom Typ eines Abwärtswandlers ist.

9. Umrichter, der dazu bestimmt ist, eine elektrische Last (M) zu steuern, und aufweist:

- ein Gleichrichtermodul (REC), das dazu bestimmt ist, eine Wechselspannung gleichzurichten, die von einem Stromversorgungsnetz (R) geliefert wird,
- einen Gleichspannungsversorgungsbus, der mit dem Gleichrichtermodul (REC) verbunden ist und eine erste Versorgungsleitung (10) mit positivem elektrischem Potential und eine zweite Versorgungsleitung (11) mit negativem elektrischem Potential aufweist, zwischen denen eine Hauptgleichspannung (Vbus) angelegt wird, die von dem Gleichrichtermodul geliefert wird,
- einen Buskondensator (Cbus), der mit der ersten Versorgungsleitung (10) und der zweiten Versorgungsleitung (11) verbunden ist,
- ein Wechselrichtermodul (INV), das mehrere Schalttransistoren aufweist, die dazu bestimmt sind, die auf dem Bus verfügbare Gleichspannung (Vbus) in eine variable Spannung umzuwandeln, die für die elektrische Last (M) bestimmt ist,

**dadurch gekennzeichnet, dass** er aufweist:

- ein Schaltnetzteil, das mit demjenigen konform ist, das in einem der Ansprüche 4 bis 8 definiert ist, und dadurch, dass die erste Klemme (X) des Schaltnetzteils mit der ersten Versorgungsleitung (10) des Gleichspannungsversorgungsbusses verbunden ist und die zweite Klemme (Y) des Schaltnetzteils mit der zweiten Versorgungsleitung (11) des Gleichspannungsversorgungsbusses verbunden ist.

**Claims**

1. Control device (1) configured to be employed in a switched electrical power supply system to control a DC/DC converter of said switched electrical power supply system, said control device comprising :

  - a first input terminal (A) and a second input terminal (B),
  - a first transistor (T1) connected to the second input terminal (B) and provided with a gate (G) intended to be connected to a control unit (U) designed to deliver control signals to its gate,
  - a second transistor (T2) in series with the first transistor (T1), and provided with a gate (G),
  - a control assembly designed to control the second transistor (T2), connected to the gate (G) of the second transistor (T2) and to the second input terminal (B) and comprising a voltage source (Vdc) and a Zener diode (Dz1) connected in series with the voltage source (Vdc),
  - several identical patterns, each pattern comprising:
  - a first connection point (M) and a second connection point (N),
  - a capacitor (Cb) connected to the first connection point (M),
  - a first Zener diode (Dz1) connected in series with said capacitor (Cb),
  - a third transistor (T3_i) provided with a gate (G) connected to said first Zener diode and with a source (S) connected to the second connection point (N),
  - a second Zener diode (Dz3) connected between the gate (G) and the source (S) of the third transistor (T3_i),
  - the first added pattern being connected up by its second connection point (N) to the drain (D) of the second transistor (T2) and by its first connection point (M) to the gate (G) of the second transistor (T2),
  - each additional pattern being connected up by its second connection point (N) to the drain (D) of the third transistor (T3_n-1) of the previous pattern and by its first connection point (M) to the gate (G) of the third transistor (T3_n-1) of the previous pattern, the drain of the third transistor of the last pattern being connected to the first input terminal (A).

2. Device according to Claim 1, **characterized in that** it comprises an additional capacitor (Cadd) connected in parallel with the Zener diode (Dz1).

3. Device according to Claim 1, **characterized in that** it comprises an additional capacitor (Cadd) connected in parallel with the control assembly.

4. Switched electrical power supply system comprising a first terminal (X) and a second terminal (Y) between which is connected a DC voltage source, a DC/DC converter connected to the first terminal (X) and a control device (1) connected in series with the DC/DC converter and to the second terminal (Y), **characterized in that** said control device (1) is in accordance with that defined in one of Claims 1 to 3.

5. System according to Claim 4, **characterized in that** the DC/DC converter is of insulated "flyback" type.

6. System according to Claim 4, **characterized in that** the DC/DC converter is of insulated "forward" type.

7. System according to Claim 4, **characterized in that** the DC/DC converter is of boost type.

8. System according to Claim 4, **characterized in that** the DC/DC converter is of buck type.

9. Variable speed drive intended to control an electrical load (M), comprising:

  - a rectifier module (REC) intended to rectify an AC voltage provided by an electrical distribution network (R),

- a DC power supply bus connected to the rectifier module (REC) and comprising a first power supply line (10) at positive electrical potential and a second power supply line (11) at negative electrical potential between which is applied a main DC voltage (Vbus) provided by the rectifier module,
- a bus capacitor (Cbus) connected to the first power supply line (10) and to the second power supply line (11),
- an inverter module (INV) comprising several switching transistors intended to convert the DC voltage (Vbus) available on the bus into a variable voltage destined for the electrical load (M),

**characterized in that** it comprises:

- a switched electrical power supply system in accordance with that defined in one of Claims 4 to 8 and **in that** the first terminal (X) of the switched electrical power supply system is connected to the first power supply line (10) of the DC power supply bus and the second terminal (Y) of the switched electrical power supply system is connected to the second power supply line (11) of the DC power supply bus.

**Fig. 1A**

**Fig. 1B**

**Fig. 2**

**Fig. 3**

Fig. 4A

Fig. 4B

Fig. 4C

Fig. 4D

Fig. 4E

*Fig. 5*

*Fig. 6*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0453376 A2

- JP 2006158185 A

**Littérature non-brevet citée dans la description**

- **ROBERT L. HESS ; RUSSEL JACOB BAKER.** Transformerless Capacitive Coupling of Gate Signais for Sériés Operation of Power MOS Devices. *IEEE transactions on power electronics,* Septembre 2000, vol. 15 (5